# EUROPEAN PATENT SPECIFICATION

(11) **EP 0 790 530 B1**
(45) Date of publication and mention of the grant of the patent: **13.06.2001**
(21) Application number: 97200445.1
(22) Date of filing: 15.02.1997
(51) Int. Cl.: G03F 7/00, B41N 3/03

(54) **Dummy plate for offset printing**
Blindplatte für den Offsetdruck
Plaques blanches pour l'impression offset

(30) Priority: 19.02.1996 EP 96200429
(43) Date of publication of application: 20.08.1997
(73) Proprietor: AGFA-GEVAERT N.V., 2640 Mortsel (BE)
(72) Inventor: Lehmann, Peter, 65779 Kelkheim (DE); Joerg, Klaus, 55218 Ingelheim (DE)

(56) References cited:
- EP-A- 0 407 081
- DE-A- 4 030 056

## Description

### 1. Field of the invention.

The present invention relates to a dummy plate for offset printing comprising essentially a mechanically and/or electrochemically roughened, anodically oxidized and hydrophilized aluminium support and a non light-sensitive, water-soluble layer coated thereon. Furthermore it relates to a method for making the dummy plate

### 2. Background of the invention.

In a printing press several plates are generally tensioned next to each other and one behind the other on an impression cylinder. Dummy plates are offset plates without ink-accepting parts. They are used when the paper web must not be completely printed. A dummy plate is tensioned on the impression cylinder there where no image may be transferred onto the paper. The objective of the dummy plate is to take up the fountain solution applied over the entire cylinder width and to transfer it to the paper web. At the same time the dummy plate may not accept the printing ink in order to avoid a transfer of the latter onto the paper ("toning"). A lot of dummy plates are necessary when separate inks in multicolour offset printing are not used on all of the pages so that the respective inking units may not transfer ink there.

Dummy plates are normally roughened and anodically oxidized aluminium plates. They can optionally have an extra hydrophilizing layer. The disadvantage of these dummy plates is that they are very sensitive to fingerprints and to other external influences. Fingerprints for example lead to ink acceptance and consequently to toning in the printing press. Furthermore it has been established that the hydrophilic characteristics of such dummy plates deteriorate upon ageing as a result of which they accept ink in the printing press and tone. This phenomenon is strongly present when the dummy plates were exposed without any protection to the ambient air for a prolonged period of time, which allowed them to take up e.g. moisture, dust or traces of oil. In order to eliminate the consequences of fingerprints and to restore the hydrophilic characteristics of the aluminium surface to the original value, dummy plates are subjected to the normal development process with subsequent gumming. Through development the printing-plate surface is cleaned and hydrophilized. A subsequent gumming preserves the surface. The tendency towards toning in the printing press is considerably less for dummy plates having received such a treatment.

### 3. Summary of the invention.

Therefore it is an object of the present invention to develop a dummy plate lacking the aforementioned disadvantages, especially the sensitivity to fingerprints and ageing. It must be ready for direct use in the printing press, even when it has not undergone a previous development process. Furthermore it must be processable without disturbance in an automatic processor with a negative developer and subsequent gumming. This extra requirement stems from the fact that in automatic plate processors all plates, including the dummy plates, are subjected to the normal development conditions.

The objective can be reached by providing a dummy plate for offset printing comprising essentially a mechanically and/or electrochemically roughened, anodically oxidized and hydrophilized aluminium support in the form of a plate, sheet or band and a non light-sensitive, water-soluble layer coated thereon. The layer is characterized in that it contains at least one organic polymer with a water-solubility of at least 2 g/L at room temperature and at least one inorganic compound reacting as an acid. Preferably the layer contains also a surfactant. Furthermore the layer can also contain a dye.

### 4. Detailed description of the invention.

DE-A 39 03 001, 40 30 056 and 38 25 836 disclose non light-sensitive layers of this kind as top layers on photopolymeric layers. In these patents their objective is to prevent the access of oxygen during the photopolymerisation. Contrary thereto the layer in the dummy plate according to the present invention is a protective layer against fingerprints, dust and other influences. Furthermore it is meant to keep the surface of the support hydrophilic even for a prolonged period of time. During development, it was found that not every water-soluble oxygen barrier layer is suitable therefore. Only the combination of water-soluble, organic polymer and inorganic compound reacting as an acid guarantees that the dummy plate can be used in the press without toning even after a prolonged storage period (2 to 3 years).

Suitable water-soluble, organic polymers are disclosed in e.g. US-A 3 458 311. Preferred are polyvinyl alcohol and partially saponified polyvinyl acetates optionally containing vinyl ether and vinyl acetal units. Specially preferred are polyvinyl alcohols still containing residual acetate groups. In case the dummy plates pass through a processing unit with negative developer, polyvinyl alcohols with a content of residual acetyl groups of at least 12 mole % are preferably used. The water-soluble, organic polymers have at room temperature a water-solubility of at least 2 g/L. The content of the water-soluble polymer generally ranges from 60 to 99.5 % by weight, preferably 70 to 95 % by weight, with respect to the total weight of the layer.

The inorganic compound reacting as an acid keeps the support hydrophilic for a long period of time when it is used in the aforementioned combination with the organic polymer. Suitable compounds are disclosed in DE-A 39 03 001 and 40 30 056. They include especially mineral acids such as phosphoric acids and sulphuric acids as well as water-soluble acid salts thereof such as phosphates. Preferred salts are ammonium phosphates and alkaline or alkaline-earth phosphates. Especially preferred are phosphoric acid, alkaline and ammonium dihydrogen phosphate. The content of the inorganic compound reacting as an acid ranges generally from 0.5 to 40 % by weight, preferably 5 to 35 % by weight, with respect to the total weight of the layer.

The optionally present surfactant is used to reduce the surface tension of the coating composition and subsequently to enhance the wettability of the support. Preferred surfactants are anionic surfactants such as sodium dodecyl sulphate, sodium dodecyl sulphonate, alkylamino carboxylates and dicarboxylates; cationic surfactants such as tetraalkyl ammonium salts; and non ionic surfactants such as polyethylene glycols having an average molecular weight up to 400.

The content of surfactant(s) ranges up to 10 % by weight, preferably 2 to 7 % by weight, with respect to the total weight of the layer. Finally, the layer can contain a dye for the visual control of the homogeneity.

In the making of the dummy plates according to the invention, a diluted aqueous solution containing the aforementioned ingredients is generally coated onto the roughened and hydrophilized aluminium support. The content of non volatile ingredients in this solution ranges advantageously from approximately 0.1 to 10 % by weight with respect to the total weight of the solution. After drying the water-soluble layer generally has a weight ranging from 0.1 to 3 g/m², preferably from 0.1 to 1 g/m².

The plates, sheets or bands out of which the dummy plates according to the invention are made, are composed of aluminium or one of its alloys. They are roughened mechanically and/or electrochemically. Preferably the roughening is carried out electrochemically in diluted hydrochloric acid. During the subsequent anodic oxidation, preferably in diluted sulphuric acid, an oxide layer is formed on the aluminium. Generally the oxidation is controlled in such a way that the oxide layer has a weight of 1 to 5 g/m².

The thus prepared aluminium material is then hydrophilized. Phosphor-containing compounds are preferably used for the hydrophilization. Especially preferred are organic polymers with phosphor-containing groups, especially phosphinic acid or phosphonic acid groups. Polymers of this kind are disclosed in e.g. EP-A 0 069 318 and 0 069 320. Especially preferred is polyvinyl phosphonic acid. The hydrophilizing agent is generally applied in the form of an aqueous solution and then dried.

It is not necessary to subject the dummy plate according to the invention to the development process, even not after a prolonged storage period. It can be tensioned on the impression cylinder of the press directly after bevelling. The water-soluble layer is stripped off by the fountain solution, setting free the hydrophilic surface of the support.

When applying the hydrophilic protective layer coating faults can occur which cause an undesired toning during printing. Such faults are avoided with the method according to the invention. This method is characterized in that the aqueous coating solution is applied several times, preferably twice, onto the roughened and hydrophilized aluminium support, and dried each time. Coating faults that occurred during the previous application can thereby be compensated. Uncoated areas leading to toning afterwards are surely avoided by this method.

The dummy plates according to the invention can be cut more easily to the desired formats than the uncoated dummy plates. The cutting tools show considerably less wear. This is attributed to the lubricating effect of the coating during cutting.

### Examples

An aluminium band roughened and anodized electrochemically in hydrochloric acid (weight of the oxide layer: 3 g/m²) and hydrophilized with a 0.2 wt % polyvinyl phosphonic acid solution in water was coated as follows:

### Example 1

A coating solution disclosed in DE-A 39 03 001, example 1, and in DE-A 40 30 056 having the following composition

| | |
|---|---|
| 1.5 wt % | polyvinyl alcohol having a hydrolysis degree of 75-79 mole % and a polymerisation degree Pₙ = 300, |
| 0.1 wt % | sodium dodecyl sulphate, |
| 0.25 wt % | phosphoric acid ( 85 wt %) and |
| 98.15 wt % | demineralized water |

was coated and dried. The dried layer had a weight of 0.5 g/m².

### Example 2

A coating solution prepared according to DE-A 40 30 056 having the following composition

| | |
|---|---|
| 1.5 wt % | polyvinyl alcohol having a hydrolysis degree of 75-79 mole % and a polymerisation degree Pₙ = 300, |
| 0.1 wt % | sodium dodecyl sulphate, |
| 0.24 wt % | ammonium dihydrogen phosphate (NH₄H₂PO₄) and |
| 98.16 wt % | demineralized water |

was coated and dried. The dried layer had a weight of 0.5 g/m².

### Comparative example

A coating solution prepared according to DE-A 38 25 836 having the following composition

| | |
|---|---|
| 6.98 wt % | polyvinyl alcohol (K-value 4, 12 mole % of residual acetyl groups), |
| 0,40 wt % | polyethylenimine (^{(R)} Polymin P from BASF AG) and |
| 92,62 wt % | demineralized water |

was coated and dried. The dried layer had a weight of 2 g/m².

Subsequently the plates were proof printed in a Roland-Favorit II press with Dahlgreen fountain solution. The uncoated plate was also included in the test for comparison purposes. The test probes together with the uncoated support were exposed to the ambient air for different time lapses during a prolonged period without packaging and without interleaves. Moisture, dust and oil traces from the air could directly affect the plate surface. Additionally fingerprints were applied on the plates before proof printing in the press. Subsequently the plates were proof printed without any further pretreatment (development). The results are summarized in table 1 at the end of the description.

Furthermore the dummy plate should be processable without any disturbance in a processing unit with negative developer and subsequent gumming . Given the fact that dummy plates also pass through the development process in automatic printing-plate processing units, the plates coated with the respective layers and the uncoated plate were processed in a processor filled with a negative developer having the following composition

| | |
|---|---|
| 3.0 parts by weight | sodium dodecyl sulphate |
| 5.4 parts by weight | potassium pelargonate |
| 4.0 parts by weight | 2-phenoxy-ethanol |
| 2.0 parts by weight | potassium tetraborate and |
| 85.6 parts by weight | demineralized water |

and gummed with gum arabic.

The plates prepared according to examples 1 and 2 (of the invention) and the uncoated plates could be processed without any problem in said processor; the plate coated according to the comparative example gave rise to problems in the processor in that a greasy residue deposited on the plate, the rollers of the processor and in the developer. Consequently the plate could not be processed any further, i.e. it was impossible to make prints with it. The plates that had passed through the processor without any problems could be printed in the press without toning.

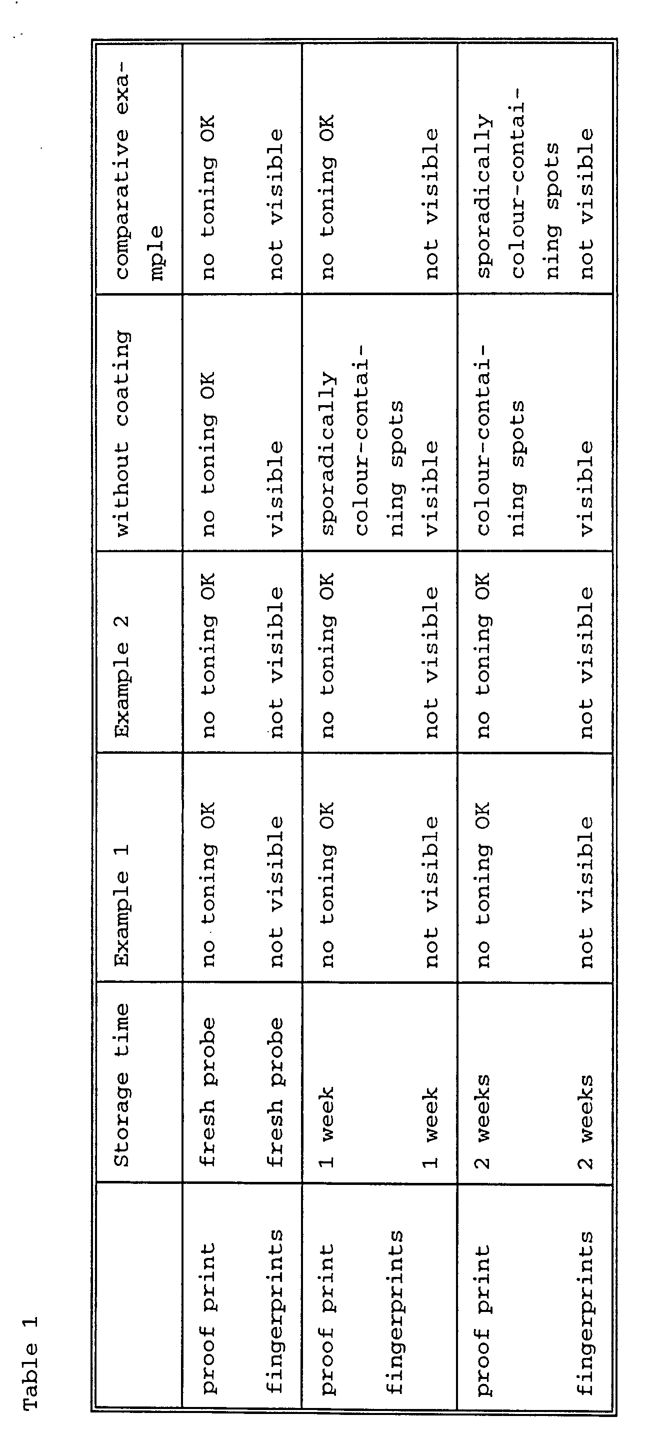

## Claims

1. Dummy plate for offset printing comprising essentially a mechanically and/or electrochemically roughened, anodically oxidized and hydrophilized aluminium support in form of a plate, sheet or band and a non light-sensitive, water-soluble layer coated thereon, characterized in that the layer contains at least one organic polymer with a water-solubility of at least 2 g/L at room temperature and at least one inorganic compound reacting as an acid.

2. Dummy plate according to claim 1, characterized in that the weight of the oxide layer ranges from 1 to 5 g/m².

3. Dummy plate according to claim 1 or 2, characterized in that the hydrophilizing agent is an organic polymer with phosphor-containing groups, preferably phosphinic acid or phosphonic acid groups.

4. Dummy plate according to claim 3, characterized in that the hydrophilizing agent is polyvinyl phosphonic acid.

5. Dummy plate according to any of claims 1 to 4, characterized in that the water-soluble organic polymer is a polyvinyl alcohol having residual acetyl groups representing preferably more than 12 mole %, and/or polyvinylpyrrolidone.

6. Dummy plate according to any of claims 1 to 5, characterized in that the content of the water-soluble organic polymer ranges from 60 to 99.5 % by weight with respect to the total weight of the layer.

7. Dummy plate according to any of claims 1 to 6, characterized in that the inorganic substance reacting as an acid is a mineral acid, preferably phosphoric or sulphuric acid, or a salt thereof reacting as an acid, preferably ammonium dihydrogen phosphate.

8. Dummy plate according to any of claims 1 to 7, characterized in that the content of the inorganic compound reacting as an acid ranges from 0.5 to 40 % by weight with respect to the total weight of the layer.

9. Dummy plate according to any of claims 1 to 8, characterized in that the layer contains a surfactant.

10. Dummy plate according to any of claims 1 to 9, characterized in that the weight of the dried water-soluble layer is in the range of 0.1 to 3 g/m².

11. Method for making a dummy plate according to any of claims 1 to 10, characterized in that coating solution is applied several times, preferably twice, and dried each time.

## Patentansprüche

1. Blindplatte für den Offsetdruck, die im wesentlichen aus einem platten-, folien- oder bandförmigen, mechanisch und/oder elektrochemisch aufgerauhten, anodisch oxidierten und hydrophilierten Aluminiumträger und einer darauf aufgebrachten, nicht lichtempfindlichen, wasserlöslichen Schicht besteht, dadurch gekennzeichnet, daß die Schicht mindestens ein in Wasser bei Raumtemperatur mit mindestens 2 g/l lösliches organisches Polymer und mindestens eine anorganische, sauer reagierende Verbindung enthält.

2. Blindplatte nach Anspruch 1, dadurch gekennzeichnet, daß das Gewicht der Oxidschicht im Bereich von 1 bis 5 g/m² liegt.

3. Blindplatte nach Anspruch 1 oder 2, dadurch gekennzeichnet, daß das Hydrophilierungsmittel ein organisches Polymer mit phosphorhaltigen Gruppen, bevorzugt Phosphinsäure- oder Phosphonsäuregruppen, ist.

4. Blindplatte nach Anspruch 3, dadurch gekennzeichnet, daß das Hydrophilierungsmittel Polyvinylphosphonsäure ist.

5. Blindplatte nach einem oder mehreren der Ansprüche 1 bis 4, dadurch gekennzeichnet, daß das wasserlösliche organische Polymer ein Polyvinylalkohol mit Restacetylgruppen, die vorzugsweise mehr als 12 mol-% ausmachen, und/oder Polyvinylpyrrolidon ist.

6. Blindplatte nach einem oder mehreren der Ansprüche 1 bis 5, dadurch gekennzeichnet, daß der Anteil des wasserlöslichen organischen Polymers 60 bis 99,5 Gew.-%, bezogen auf das Gesamtgewicht der Schicht, beträgt.

7. Blindplatte nach einem oder mehreren der Ansprüche 1 bis 6, dadurch gekennzeichnet, daß die anorganische, sauer reagierende Substanz eine Mineralsäure, bevorzugt Phosphor- oder Schwefelsäure, oder ein sauer reagierendes Salz davon, bevorzugt Ammoniumdihydrogenphosphat, ist.

8. Blindplatte nach einem oder mehreren der Ansprüche 1 bis 7, dadurch gekennzeichnet, daß der Anteil der sauer reagierenden, anorganischen Verbindung 0,5 bis 40 Gew.-%, bezogen auf das Gesamtgewicht der Schicht, beträgt.

9. Blindplatte nach einem oder mehreren der Ansprüche 1 bis 8, dadurch gekennzeichnet, daß die Schicht ein Tensid enthält.

10. Blindplatte nach einem oder mehreren der Ansprüche 1 bis 9, dadurch gekennzeichnet, daβ das Gewicht der getrockneten, wasserlöslichen Schicht 0,1 bis 3 g/m² beträgt.

11. Verfahren zur Herstellung einer Blindplatte nach einem oder mehreren der Ansprüche 1 bis 10, dadurch gekennzeichnet, daß mehrmals, bevorzugt zweimal, Beschichtungslösung aufgebracht und jeweils getrocknet wird.

## Revendications

1. Faux-cliché pour l'impression offset comprenant essentiellement un support en aluminium rendu rugueux par voie mécanique et/ou par voie électrochimique, soumis à une oxydation anodique et rendu hydrophile, sous la forme d'un cliché, d'une feuille ou d'une bande, et une couche hydrosoluble non photosensible coulée sur le premier cité, caractérisé en ce que la couche contient au moins un polymère organique dont la solubilité dans l'eau s'élève à au moins 2 g par litre à la température ambiante, et au moins un composé inorganique réagissant à la manière d'un acide.

2. Faux-cliché selon la revendication 1, caractérisé en ce que le poids de la couche d'oxyde se situe dans le domaine de 1 à 5 grammes par mètre carré.

3. Faux-cliché selon la revendication 1 ou 2, caractérisé en ce que l'agent rendant hydrophile est un polymère organique contenant des groupes phosphorés, de préférence des groupes d'acide phosphinique ou d'acide phosphonique.

4. Faux-cliché selon la revendication 3, caractérisé en ce que l'agent rendant hydrophile est l'acide polyvinylphosphonique.

5. Faux-cliché selon l'une quelconque des revendications 1 à 4, caractérisé en ce que le polymère organique hydrosoluble est un alcool polyvinylique possédant des groupes acétyle résiduels représentant de préférence plus de douze moles % et/ou la polyvinylpyrrolidone.

6. Faux-cliché selon l'une quelconque des revendications 1 à 5, caractérisé ce que la teneur du polymère organique hydrosoluble se situe dans le domaine de 60 à 99,5 % en poids par rapport au poids total de la couche.

7. Faux-cliché selon l'une quelconque des revendications 1 à 6, caractérisé en ce que la substance inorganique réagissant à la manière d'un acide est un acide minéral, de préférence l'acide phosphorique ou l'acide sulfurique ou encore un de ses sels réagissant à la manière d'un acide, de préférence le dihydrogénophosphate d'ammonium.

8. Faux-cliché selon l'une quelconque des revendications 1 à 7, caractérisé en ce que la teneur du composé inorganique réagissant à la manière d'un acide se situe dans le domaine de 0,5 à 40 % en poids par rapport au poids total de la couche.

9. Faux-cliché selon l'une quelconque des revendications 1 à 8, caractérisé en ce que la couche contient un agent tensioactif.

10. Faux-cliché selon l'une quelconque des revendications 1 à 9, caractérisé en ce que le poids de la couche hydrosoluble séchée se situe dans le domaine de 0,1 à 3 grammes par mètre carré.

11. Procédé pour fabriquer un faux-cliché selon l'une quelconque des revendications 1 à 10, caractérisé en ce qu'on applique une solution de coulée à plusieurs reprises, de préférence deux fois, et on sèche à chaque fois.
